Europäisches Patentamt

European Patent Office

Office européen des brevets

(11) Publication number: **0 272 498**

**A2**

# (12) EUROPEAN PATENT APPLICATION

(21) Application number: 87117583.2

(51) Int. Cl.⁴: **G03F 7/08**

(22) Date of filing: 27.11.87

(30) Priority: 22.12.86 US 944627

(43) Date of publication of application:
29.06.88 Bulletin 88/26

(84) Designated Contracting States:
DE FR GB IT

(71) Applicant: International Business Machines
Corporation
Old Orchard Road
Armonk, N.Y. 10504(US)

(72) Inventor: Brunsvold, William Ross
22 Clover Hill Road
Poughkeepsie New York 12603(US)
Inventor: McDonnell Bushnell, Lorraine P.
RD8 Westleigh Road
Carmel New York 10512(US)
Inventor: Chow, Ming-Fear
Beyer Drive
Poughkeepsie New York 12570(US)
Inventor: Lyons, Christopher Francis
408 Beaver Road
LaGrangeville New York 12540(US)

(74) Representative: Klein, Daniel Jacques Henri
Compagnie IBM France Département de
Propriété Intellectuelle
F-06610 La Gaude(FR)

(54) **Base-soluble ultraviolet photoresists having styrene maleimide resins.**

(57) Styrene-maleimide copolymers are combined with bisazide sensitizers to form negative, base soluble Deep UV resists. An alkylation process is used to modify the styrene-maleimide copolymer to form a styrene-maleimide-N-methyl maleimide terpolymer. The terpolymer is combined with Mid UV and Deep UV photoactive compounds to give base soluble, positive photoresists having improved lithographic performance.

EP 0 272 498 A2

# BASE-SOLUBLE ULTRAVIOLET PHOTORESISTS HAVING STYRENE MALEIMIDE RESINS

Background of the Invention

The present invention relates to photoresists, and more particularly to photoresists based on styrene maleimide resins which are base-soluble and sensitive to deep ultraviolet radiation.

Two types of photoresists are available, negative-acting and positive-acting photoresists. The principal components of both types are a polymer, a sensitizer, and a solvent system. Prior to exposure, negative-acting resists are soluble in developer, but with exposure they undergo chemical change and become insoluble in such developers. After selective exposure, the unexposed areas of the photoresist are selectively dissolved, softened, or washed away, leaving the desired resist pattern on a substrate. The remaining resist pattern is used to protect the substrate in, for example, etching processes, where surface etching of the substrate is desired only in the areas which underlie the unexposed resist. Negative resists typically use resins having residual unsaturation such as the widely used cyclized polyisoprene derivatives and polybutadiene or use resins which are capable of crosslinking. A sensitizer such as an azide is added which forms a reactive intermediate upon exposure to induce crosslinking with the resin. These resists are developed in either organic or aqueous base solvents.

Positive-acting resists work in the opposite manner, with exposure making the resists soluble in the developer. The photoactive component is typically a diazonapthoquinone sensitizer which is converted to a carboxylic acid upon exposure. The polymers used in positive photoresists are usually cresylic acid (novolac) resins and are not photoactive at the dose required to convert sensitizer to acid. Novolac resins are selected for their film forming properties and as a matrix for the sensitizer. The resins used have some affinity for water. Since the photoactive compounds are non-polar and hydrophobic prior to photolysis, they act as dissolution inhibitors and make the unexposed portions relatively insoluble in aqueous developer. Exposure results in photolysis of the photoactive compound and the exposed areas are removed in aqueous developing solutions which are mildly alkaline.

Both positive-acting and negative-acting resists have disadvantages which are well known in the art. Positive-acting resists typically suffer from thermal instability at higher processing temperatures (160-200°C). A thermally stable photoresist is one which does not flow excessively at a given temperature and one in which images in the resist undergo little or no dimensional change or distortion at a given temperature. Conventional photoresists are available which are thermally stable to about 160°C, and while they are useful at temperatures up to 160°C, their thermal stability above 160°C is such that they are not suggested for use in high temperature processes such as plasma etching, sputtering, ion implantation, and the like.

Some negative-acting resists have been proposed which are stated to have improved thermal properties. However, negative-acting resists have inherently poor resolution because of the swelling caused by the organic solvent developers or have high absorbance at the exposure wave-length which results in concave profiles.

The demand for 1 micron and submicron geometries for semiconductor device manufacturing is increasing rapidly. Multilayer resist (MLR) technology with step and repeat exposure tools can achieve submicron images, but the processes are lengthy and expensive. The most cost effective method appears to be a single layer Mid UV (MUV) or Deep UV (DUV) resist imaged with a projection printer. In DUV applications, additional constraints are placed on the resin. Conventional positive resins for Mid UV lithography (300-400 nm) such as Novolac (phenol formaldehyde) resins are not acceptable for Deep UV (200-300 nm) because of their high optical density (O.D.) below 300 nm. Polymers having a low weight-average molecular weight of about 20,000 and a 1:1 molar ratio of styrene residues to maleimide residues in an alternating vinyl polymer structure have been disclosed. These polymers are stable to 380°C. It has also been disclosed that polymer solubility can be controlled by incorporating N-alkyl maleimide monomers or alkyl substituted styrene monomers during polymer formation. However, the synthesis of poly(styrene-co-maleimide-co-N-methyl-maleimide) from monomer components results in polymer which is not sufficiently soluble in the typical resist casting solvent diglyme. Synthesis from monomer components is difficult to control because of the higher reactivity of N-methylmaleimide compared to maleimide. This makes it difficult to achieve the minimum 10 mole % of CO-NH-CO groups required for reasonable solubility in aqueous base.

Problems have also been encountered when trying to formulate DUV negative resists. The use of bis azido aryl compounds (bisazides) as negative sensitizers for UV photoresists has been described. Photolysis of these resist films generates reactive aryl nitrenes which crosslink the resins.

Iwayangagi, et al., IEEE Trans. Electron Devices, ED-28. 1306 (1981) discloses formulations of poly vinylphenol with azides to give negative working resists which can be exposed in the Deep UV. However, the dissolution rate of the resist is too fast and the O.D. (optical density) of the polymer is too high to allow acceptable images and a usable process window. Other formulations combined near UV sensitive bisazides with aliphatic diene polymers like cyclized polyisoprene and polybutadiene. These near UV resists have poor resolution because of swelling by the organic solvent developers and poor resist properties because of the lack of etch resistance of these polymers. Recent developments have centered on the use of bisazide sensitizers with phenolic resins. However, the effectiveness of these materials as DUV resists is hampered by the strong DUV absorption of these resins. The effect of this absorption produces undercut images which limits their usefulness as an etch mask and makes resolution of small features (i.e. 1.0 micron) difficult. In addition, these resists exhibit the low thermal stability characteristic of novolac resins.

Summary of the Invention

Accordingly, it is an object of the present invention to improve the photoresists used for lithography with ultraviolet light.

It is another object of this invention to provide negative Deep UV resist formulations that are aqueous base soluble.

It is yet another object of the invention to improve the synthesis of styrene-maleimide polymers used as photoresist binder resins with positive photoactive compounds.

It is a further object of the invention to controllably and reproducibly reduce the dissolution rate of styrene-maleimide polymers used with positive photoactive compounds.

It is another object of the invention to provide improved positive Mid UV and Deep UV photoresists having styrene-maleimide polymers.

These and other objects are achieved by combining styrene-maleimide copolymers with bisazide sensitizers to form negative, base soluble Deep UV resists. Useful bisazide sensitizers include 3,3'-diazidobenzophenone, 4,4'-diazidodiphenylsulfide, and 3,3'-diazidodiphenylsulfone. The preferred copolymer is poly(4-t-butylstyrene-co-maleimide) with a molecular weight of from about 5000 to about 32,000. A preferred process using the bisazide photoresists incorporates a polyvinyl alcohol layer overlaying the resist. This layer acts as an O2 barrier to improve sensitivity and minimize film thinning in the exposed region. In an alternative embodiment, an alkylation process is used to modify the styrene-maleimide copolymer to form a styrene-maleimide-N-methyl maleimide terpolymer. The alkylation process described allows the dissolution rate of the styrene-maleimide polymers to be reduced controllably and reproducibly. This enables improved process control during photoresist development. The terpolymer is combined with Mid UV positive photoactive compounds to give base soluble, positive photoresists having improved lithographic performance. The preferred Mid UV positive photoactive compound is 4,8-Bis-(6-diazo-5,6-dihydro-5-oxo-1-napthalene sulfonyl oxymethyl)tricyclo(5.2.1.02,6)decane. The terpolymer can also be combined with Deep UV positive photoactive compounds to give base soluble, positive photoresists with improved lithographic performance. The preferred Deep UV positive sensitizer is 1,1'-(dodecamethylene)Bis(2,4-piperidinedione).

Description of the Preferred Embodiments

The following synthetic procedure describes the preferred method for making the photoresist compositions and their precursors. The following procedure also describes the preferred process for using the present invention.

COPOLYMER PREPARATION

The copolymers are prepared by reacting maleimide monomers with styrene or substituted styrene monomers. Copolymer synthesis is described in P.O. Tawney, et al., J. Org. Chem. 26 15 (1961). Typical substituted styrene monomers include alpha-methylstyrene, 2,4-dimethyl-styrene, 4-methylstyrene, 4-ethylstyrene, 4-isopropyl-styrene, or 4-tert-butylstyrene. Preferred copolymers contain 40-60% maleimide residues and 40-60% styrene residues.

The copolymers are prepared under typical free radical vinyl polymerization conditions in a suitable liquid polymerization solvent. Polymerization temperatures and pressures are not critical. Reaction conditions can be varied in ways well known to those skilled in the art of free radical vinyl polymerization in order to obtain desired reaction rates and molecular weights. Preferred compositions have low weight average molecular weights (5,000-32,000) and a molar ratio of styrene to maleimide of 1:1. Examples of copolymer preparation techniques can be found in EPO published application N°140273, portions of which are included hereinafter as Examples 1-4. EPO published application N°140273 is incorporated herein by reference.

## EXAMPLE 1

Preparation of maleimide-styrene copolymer

Maleimide-styrene copolymer is prepared by copolymerizing, in a sealed tube and in the absence of air, 4.00 g of maleimide with 4.29 g of styrene dissolved in a suitable solvent. Azobisisobutyronitrile (42 mg) is used as an initiator. The tube containing the reaction mixture is deoxygenated with argon for 10 minutes, and is then sealed and heated in an oven in a solvent (dimethylformamide, methanol, or cyclohexanone). By varying the reaction time and the temperature, copolymers having varying molecular weights are obtained. Isolation of the polymer is accomplished by precipitation by pouring the reaction mixture into 500 ml of methanol. The solid polymer is crushed, washed with methanol, and dried in vacuum.

## EXAMPLE 2

Preparation of 4-tert-butylstyrene maleimide copolymer

Four grams of maleimide, 6.6 g of 4-tert-butylstyrene, 42 mg of azobisisobutyronitrile and 40 mL of cyclohexanone are mixed and deoxygenated with argon. The solution is heated in a sealed tube at 60°C for 4 hours. The resulting polymer is isolated by pouring the polymer solution into cold water, filtering, washing and drying under vacuum.

## XAMPLE 3

Preparation of 4-ethylstyrene maleimide copolymer

Four grams of maleimide, 5.44 g of 4-ethylstyrene, 42 g of azobisisobutyronitrile, and 32 mL of dimethylformamide are deoxygenated with argon and heated in a sealed tube at 90°C for 48 hours. The polymer is recovered by pouring the reaction mixture into water, grinding, filtering and washing the precipitated polymer with methanol. The polymer is air-dried at 60°C for 12 hours.

## EXAMPLE 4

Preparation of 4-isopropylstyrene maleimide copolymer

The procedure of example 3 is followed, except that 6.04 g of 4-isopropylstyrene is substituted for 4-ethylstyrene.

## TERPOLYMER PREPARATION

## EXAMPLE 5

Alkylation of styrene maleimide copolymer to form terpolymer

Ten grams of copolymer prepared according to Example 1 were dissolved in 40 g of diglyme. Potassium t-butoxide (6 g, 1.1 equiv.) was added with stirring to give a precipitate. After 10 minutes, methyl iodide (7.6 g) was added and the reaction mixture was stirred 30 minutes at 23°C. The solution was filtered to remove insolubles. The filtrate was precipitated by slow addition to methanol. The polymer was vacuum dried to afford 9.1 g of a colorless solid poly(styrene-co-N-methylmaleimide-co-maleimide).

This method of alkylation of styrene maleimide copolymer is a more reliable method for synthesizing terpolymer having NMe:NH ratio of less than 10:1 than the method for synthesizing terpolymer from the three monomer components. The latter process is likely to result in terpolymer where the NMe:NH ratio is greater than 10:1 because of the higher reactivity of N-methylmaleimide compared to maleimide. The alkylation procedure typically affords a terpolymer with a NMe:NH ratio between 1:1 and 9:1 according to infrared analysis. Resins formed from synthesis of terpolymer by alkylation of the copolymer combined with a Mid UV sensitizer resulted in a resist having improved lithographic performance as compared to resists formed from terpolymer synthesized from three monomer components. This improvement should be extendable to a Deep UV resist formed by combining the terpolymer with a Deep UV sensitizer such as 1,1'-(dodecamethylene)Bis(2,4-piperidinedione).

## SENSITIZER PREPARATION

Preparation of negative bisazide sensitizers

Synthetic procedures for the bisazides are similar and the following procedure for preparation of 3,3'-diazidobenzophenone is exemplary.

## EXAMPLE 6

Preparation of 3,3'-diazidobenzophenone

Some 18.5 g of 3,3'-diaminobenzophenone is mixed with 100 mL of concentrated sulfuric acid and 50 mL of water, then the solution is cooled down to 5°C by using a dry ice/isopropyl alcohol bath. A solution of 34.5 g NaNO2 in a minimum amount of water (approx. 75 mL) is added dropwise, and the temperature of the mixture is maintained below 10°C for 6 hours. This aqueous sodium nitrite solution is added until an excess is indicated by starch-potassium iodide strips. After 6 hours, an aqueous solution of 32.5 g of sodium azide is added. When the evolution of nitrogen subsides, the reaction mixture is diluted with water and the precipitate is collected by suction filtration. This product is further purified by recrystallization in isopropyl alcohol to give 15 g of 3,3'-diazidobenzophenone.

Preparation of positive sensitizers

EXAMPLE 7

Preparation of 4,8-Bis(6-diazo-5,6-dihydro-5-oxo-1-naptha lene sulfonyl oxymethyl)tricyclo(5.2.1.02,6)-decane (TDQ)

Prepared according to U.S. 4,397,937, incorporated herein by reference.

EXAMPLE 8

Preparation of 1,1'-(dodecamethylene) Bis(2,4-piperidinedione)

Prepared according to U.S. 4,522,911, incorporated herein by reference.

PHOTORESIST PREPARATION

Photoresists are formulated by dissolving the polymer in diglyme by shaking or otherwise agitating for several hours. The sensitizer and any additives are then added and the mixture is agitated for another hour until a homogeneous solution is achieved. The resulting mixture is filtered to 0.2 microns.

Preparation of negative bisazide photoresists

The following examples are based on para t-butyl styrene/maleimide copolymer which is the preferred copolymer for use with the bisazide sensitizers. However, other copolymers and terpolymers can also be used.

EXAMPLE 9   poly(4-t-butylstyrene-co-maleimide copolymer) (MW = 5000)     4.10 g
di-octyl adipate     0.82 g
3,3'-diazidobenzophenone     0.90 g
diglyme     14.18 g

EXAMPLE 10   poly(4-t-butylstyrene-co-maleimide copolymer) (MW = 5000)     8.5 g
3,3'-diazidobenzophenone     1.5 g
diglyme     40.0 g

EXAMPLE 11   poly(4-t-butylstyrene-co-maleimide copolymer) (MW = 5000)     8.5 g
4,4'-diazidodiphenylsulfide     1.5 g
diglyme     40.0 g

EXAMPLE 12   poly(4-t-butylstyrene-co-maleimide copolymer) (MW = 5000)     8.5 g
3,3'-diazidodiphenylsulfone     1.5 g
diglyme     40.0 g

EXAMPLE 13   poly(4-t-butylstyrene-co-maleimide copolymer) (MW = 15000)     8.5 g
4,4'-diazidodiphenylsulfide     1.5 g
diglyme     40.0 g

EXAMPLE 14   poly(4-t-butylstyrene-co-maleimide copolymer) (MW = 32000)     8.5 g
4,4'-diazidodiphenylsulfide     1.5 g
diglyme     40.0 g

EXAMPLE 15   poly(4-t-butylstyrene-co-maleimide copolymer) (MW = 15000)     8.8 g
4,4'-diazidodiphenylsulfide     1.2 g
diglyme     40.0 g

EXAMPLE 16   poly(4-t-butylstyrene-co-maleimide copolymer) (MW = 15000)     8.0 g
4,4'-diazidodiphenylsulfide     2.0 g
diglyme     40.0 g

EXAMPLE 17 poly(4-t-butylstyrene-co-maleimide copolymer) (MW = 15000) 7.5 g
4,4'-diazidodiphenylsulfide 2.5 g
diglyme 40.0 g

Preparation of positive photoresists

EXAMPLE 18

Preparation of 4,8-Bis(6-diazo-5,6-dihydro-5-oxo-1-napthalene sulfonyl oxymethyl)tricyclo(5.2.1.02,6) decane (TDQ) photoresist Terpolymer (from Example 5) 6.7 g
TDQ 1.0 g
diglyme 33.3 g

This formulation resulted in a photoresist with 21% by weight solids. The range used was from 18-21% by weight solids. Solids contents as high as 25% by weight could probably be used, but a higher exposure dose would be necessary. The preferred weight % solids is 21%.

The MW of the terpolymer can be varied from 10,000 to 32,000.

EXAMPLE 19

Preparation of 1,1'-(dodecamethylene) Bis(2,4-piperidinedione) photoresist Terpolymer (from Example 5) 6.7 g
1,1'-(dodecamethylene)Bis(2,4-piperidinedione) 1.0 g
diglyme 33.3 g

This formulation would result in a photoresist with 21% by weight solids. A range of 18-25% would probably by effective, with higher % solids requiring higher exposure doses.

The MW of the terpolymer could be varied from 10,000 to 32,000.

COATING OF PHOTORESISTS

Eighty-two millimeter silicon wafers with 5000 Angstroms of silicon dioxide were cleaned in a sulfuric/nitric bath and rinsed in deionized water. This was followed by air drying. Wafers to be coated with positive photoresists were subjected to an adhesion promotion pretreatment by suspending them above a refluxing bath of 80:20 Freon TF/HMDS.

Photoresists were coated by puddling 2 ml of the resist in the center of the wafer and spinning for 30 seconds at 4000 rpm. For positive photoresists this was followed by a bake at 80°C for 15 minutes to give 1.0-1.2 micron thick films by Talystep measurement. For negative photoresists this was followed by a bake at 90°C for 30 minutes to give a 1.0 micron thick film by Talystep measurement.

In a preferred embodiment, wafers coated with negative photoresist were subsequently coated with a solution of 4.5% polyvinyl alcohol (PVA) in water and baked at 80°C for 3 minutes to obtain a PVA film 1000 Angstroms thick. The PVA layer is transparent to the UV radiation. During exposure the presence of oxygen causes a reaction which competes with the crosslinking of the resist. The PVA layer acts as an O2 barrier to improve sensitivity and minimize film thinning in the exposed regions. It can be removed at any time after exposure of the photoresist. It has been found that the PVA layer is conveniently removed by the aqueous base developer during development of the resist.

EXPOSURE AND DEVELOPMENT OF PHOTORESISTS

EXAMPLE 20

The photoresist formulation of Example 9 was coated according to the procedure described above for negative photoresists. One sample was overcoated with PVA and one sample was not. The wafers were then patern-wise exposed to radiation in the 240-280 nm range on a Perkin-Elmer 500 operated in the UV-2 mode. The total energy was approximately 100 mJ/cm2. Images were developed by immersing the wafers in a solution of a commercially available KOH developer, (AZ 2401, available from Azoplate Co.) diluted to a concentration of 0.125 N with water for 6 minutes to dissolve the PVA and the unexposed resist and form a negative image of the photomask pattern. The sample with the PVA overcoat retained 99% of the starting resist thickness, while the sample with no overcoat retained 65%.

EXAMPLE 21

The photoresist formulation of Example 10 was coated according to the procedure described above for negative photoresists. The wafers were overcoated with PVA. The wafers were then pattern-wise exposed to radiation in the 240-280 nm range on a Perkin-Elmer 500 operated in the UV-2 mode at a scan setting of 5000. The total energy was approximately 40 mJ/cm2. Images were developed by immersing the wafers in a solution of a commercially available KOH developer, (AZ 2401, available from Azoplate Co.) diluted to a concentration of 0.20 N with water for 2 minutes to dissolve the PVA layer and the unexposed resist and form a negative image of the photomask pattern. Excellent reproduction of the mask pattern was obtained. SEM cross-section analysis showed good quality 1 micron images.

## EXAMPLE 22

The photoresist formulation of Example 11 was coated, exposed and developed as in Example 21. Excellent reproduction of the mask pattern was obtained. SEM cross-section analysis showed good quality 1 micron images with vertical profiles.

## EXAMPLE 23

The photoresist formulation of Example 12 was coated, exposed and developed as in Example 21. Excellent reproduction of the mask pattern was obtained.

## EXAMPLE 24

The photoresist formulation of Example 13 was coated, exposed and developed as in Example 22. Excellent results were obtained.

## EXAMPLE 25

The photoresist formulation of Example 14 was coated, exposed and developed as in Example 22. The images could not be developed cleanly. A persistent residue in the unexposed areas was observed.

## EXAMPLE 26

The photoresist formulation of Example 15 was coated, exposed and developed as in Example 24. Excellent reproduction of the mask was obtained, but the percentage of the original film thickness retained was slightly lower than in Example 24.

## EXAMPLE 27

The photoresist formulation of Example 16 was coated, exposed and developed as in Example 24. Excellent reproduction of the mask was obtained.

## EXAMPLE 28

The photoresist formulation of Example 17 was coated, exposed and developed as in Example 24. Excellent reproduction of the mask was obtained, but subsequent precipitation of a portion of the sensitizer from the resist solution was observed.

## EXAMPLE 29

The photoresist formulation of Example 18 was coated according to the procedure described above for positive photoresists. The wafers were then pattern-wise exposed to radiation in the 300-400 nm range on a Perkin-Elmer 500 with a UV-3 filter at a scan setting of 5000. The total energy was approximately 100 mJ/cm2. Images were developed by immersing the wafers in a stirred solution of diluted 1:4.5 AZ 2401. Development was at room temperature and required 30 seconds to 2 minutes. The wafers were then rinsed in deionized water. Images of 2.5 microns have about a 55 degree sidewall angle. There was no unexposed film loss as compared to considerable loss when unmethylated polymer was used. As a result the unmethylated version gives sidewall angles much less than 55 degrees. Occasional scumming was observed which may be due to residual solvent or impurities from the polymer. These problems should be resolved by a better purification method.

## EXAMPLE 30

The photoresist formulation of Example 19 can be coated according to the procedure described above for positive photoresists. The wafers would then be pattern-wise exposed to radiation in the 240-280 nm range on a Perkin-Elmer 500 with a UV-2 filter at a scan setting of 5000. The total energy would be approximately 100 mJ/cm2. Images would be developed by immersing the wafers in a stirred solution of diluted 1:4.5 AZ 2401. Development would be at room temperature and should require 30 seconds to 2 minutes. The wafers would then be rinsed in deionized water.

## Claims

1. A photoresist composition comprising:

an alkali soluble polymer having styrene-based units and maleimide-based units; and

a bisazide sensitizer in an amount effective to crosslink said polymer and render it alkali insoluble upon exposure to ultraviolet light.

2. The photoresist composition according to claim 1 wherein the bisazide sensitizer comprises from 12-25% of the composition by weight.

3. The photoresist composition according to claim 2 wherein said bisazide sensitizer is a member of the group consisting of 3,3'-diazidobenzophenone, 3,3'-diazidodiphenylsulfone, and 4,4'-diazidodiphenylsulfide.

4. The photoresist according to claim 3 wherein said alkali soluble polymer is poly(4-t-butylstyrene-co-maleimide).

5. The photoresist composition according to claim 4 wherein the molecular weight of the polymer is 5,000-32,000.

6. A photoresist composition comprising:

an alkali soluble terpolymer formed by alkylation of the maleimide units of a styrene-maleimide copolymer; and

a positive photoactive compound in an amount effective to render the photoresist composition insoluble in alkaline developer prior to exposure and becoming more soluble in alkaline developer after exposure.

7. A photoresist composition according to claim 6 wherein said positive photoactive compound is a diazohomotetramic acid compound having the formula

wherein R1 is hydrogen or an alkyl group and R2 is an arylalkyl group, an aryl group, or a bifunctional group linking two of the rings together.

8. The photoresist composition according to claim 7 wherein said photoactive compound is 1,1'-(dodecamethylene)Bis(2,4-piperidinedione).

9. A photoresist composition according to claim 6 wherein said positive photoactive compound is a bisester of a 1-oxo-2-diazonaphthalene sulfonic acid and of an unsymmetrical primary or secondary aliphatic diol which is a mixture of geometric and diasterioisomers, said photoactive compound present in an amount sufficient to render the photoresist composition insoluble in alkaline developer prior to exposure and becoming more soluble in alkaline developer after exposure.

10. The photoresist composition according to claim 9 wherein said photoactive compound is 4,8-Bis(6-diazo-5,6-dihydro-5-oxo-1-napthalene sulfonyl oxymethyl) tricyclo(5.2.1.02,6)decane.

11. The photoresist composition according to claim 7 wherein said terpolymer is poly(styrene-co-N-methylmale-imide-co-maleimide).

12. The photoresist composition according to claim 9 wherein said terpolymer is poly(styrene-co-N-methyl-maleimide).

13. A method for producing a lithographic image comprising the steps of:

casting a uniform film of a solution of the photoresist composition of claim 1 in a suitable casting solvent on a surface of a substrate;

treating said film to remove said casting solvent;

coating a uniform layer of polyvinyl alcohol in a solvent over said photoresist film;

treating said layer to remove said solvent;

pattern-wise exposing said films through a mask to ultraviolet radiation; and

contacting said films with an alkaline developer to remove the polyvinyl alcohol layer and the unexposed portions of said film.